Europäisches Patentamt

European Patent Office

Office européen des brevets

(11) Publication number: **0 349 964**
**A2**

## (12) EUROPEAN PATENT APPLICATION

(21) Application number: **89112138.6**

(22) Date of filing: **03.07.89**

(51) Int. Cl.⁴: **B26F 1/38**

(30) Priority: **07.07.88 JP 89432/88**

(43) Date of publication of application:
**10.01.90 Bulletin 90/02**

(84) Designated Contracting States:
**CH DE FR GB IT LI**

(71) Applicant: **KIMOTO & CO., LTD.**
**2-7-1 Shinjuku Shinjuku-ku**
**Tokyo(JP)**

(72) Inventor: **Morozumi, Kunio**
**561 Touta Wakakusa-cho**
**Nakakoma-gun Yamanashi-ken(JP)**

(74) Representative: **MEISSNER, BOLTE &**
**PARTNER**
**Widenmayerstrasse 48 Postfach 860624**
**D-8000 München 86(DE)**

(54) **Cutting device for masking film.**

(57) This invention concernes a cutting device used in making a cut mask, which comprises a hollow frame (1) with a lower flat sliding surface and a cutter (8) supported rotatably by a supporting arm (2) secured to the frame (1) and being urged down by resilient means (14) with the point of the cutting edge of the cutter (8) being offset from the axis of rotation of the cutter (8) which is orthogonal to the lower sliding surface, so that it is possible to hold the cutter (8) always at a certain angle under a certain pressure, thereby facilitating the work of cutting.

FIG. I

## Cutting Device for Masking Film

This invention relates to a cutting device used in making a cut mask for photoengraving.

Hitherto, the work of making a cut mask for photoengraving was achieved by superposing a mask film on an original photo and moving a cutter along the outline of the image on the photo so that the cut mask being identical with the original could be made.

However, when this work was carried out by a worker holding an ordinary cutter in his hand, the pressure on the cutter was not constant. It was difficult to hold the cutter always at the same angle. The angle of the cutting edge varied; thus, it was not easy to make a precise cut mask quickly and accurately.

The objective of the present invention is to provide a cutting device for making a cut mask which enables anyone not skilled to make a cut mask for photoengraving easily and accurately that was hitherto for difficult to do.

Another objective of the present invention is to provide a cutting device to make a cut mask which permits adjustment of the pressing force of the cutter against a mask film as required so that the work of cutting can always be achieved easily, finely and satisfactorily.

The above-described drawbacks in the prior art devices have been successfully eliminated by the present invention in which a

cutting device used in making a cut mask according to the present invention comprises a frame of hollow cylindrical shape having a lower flat sliding surface, a supporting arm secured to the frame whose distal end extends to the center of the frame; a rotating cutter supported by a cutter supporting member secured to the distal end of the supporting arm the axial line of rotation of said cutter being arranged orthogonal to the lower sliding surface, and resilient means for vertically supporting the cutter, wherein the cutter has a cutting point which is offset sideways from the axial line of rotation.

As a preferred feature, a magnifying lens is attached with a curvature-adjustable supporting rod to a curved portion of the cutter supporting arm or at a position where the work is not hindered. The pressing force of the cutter can be adjusted by a coiled spring and an adjusting screw provided in the upper portion of the cutter attaching member.

These and other objective of the invention will become apparent from the following description of the essential parts when taken together with the drawings, in which

Figs. 1 through 3 show a first embodiment of the device according to the present invention in which:

Fig. 1 is a front view with the important portion shown in cross section;

Fig. 2 is a plan view; and

Fig. 3 is a front view with the important portion including a different cutter shown in cross sectional; and

Figs. 4 through 7 show a second embodiment of the present invention in which:

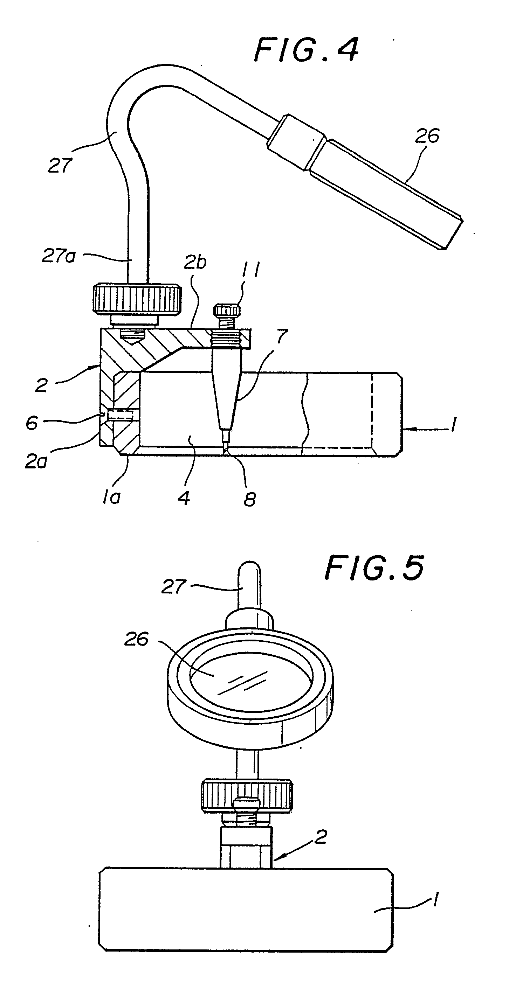

Fig. 4 is a side view;

Fig. 5 is a front view;

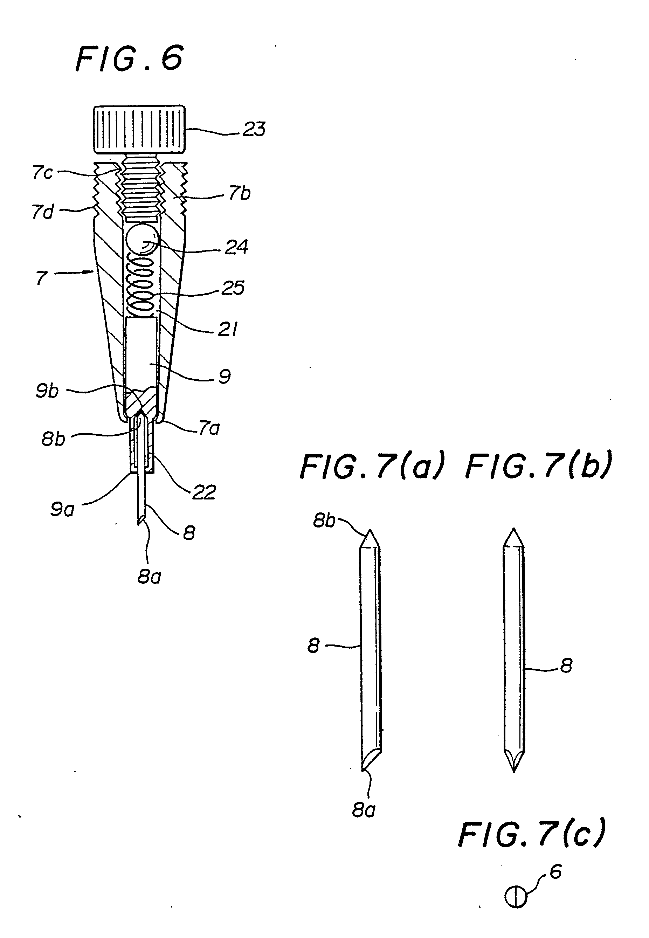

Fig. 6 is a sectional view of the cutter supporting member; and

Fig. 7 is a set of enlarged views showing the configuration of the cutter in which (a) is a side view, (b) a front view, and (c) a bottom view.

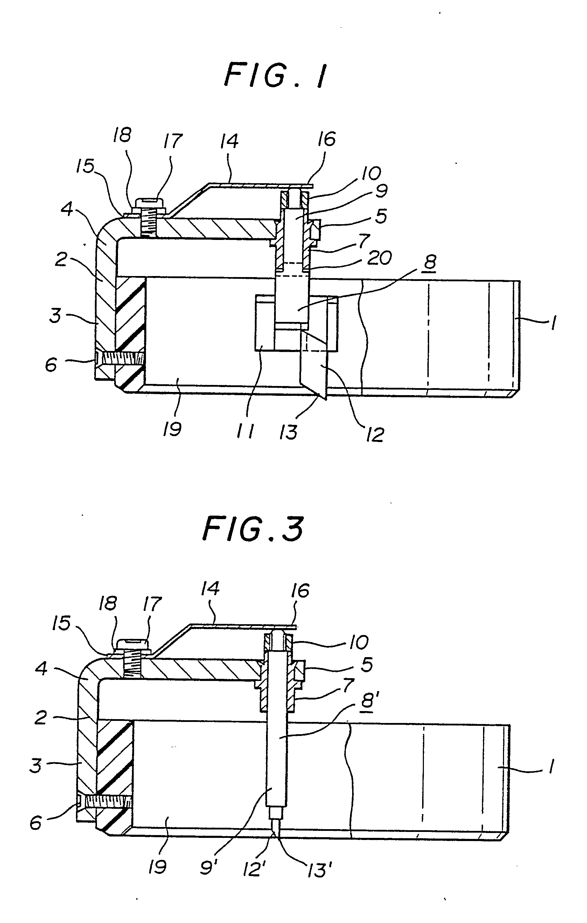

In Fig. 1 reference numeral 1 designates a frame of hollow cylindrical shape which has a lower flat sliding surface. At the outer periphery of this frame 1 of about 6 cm in outer diamter an inverted L-shaped supporting arm 2 made of aluminum is supported whose base end portion 3 is secured the frame 2 at one side thereof by a setscrew 6, and a distal end portion 5 of this arm extends to and above the central portion of the hollow portion 19 of frame 1. This distal end portion 5 supports a rotational bearing 7, a supportin shaft 9 of a cutter 8 whose axial line of rotation is orthogonal to the lower sliding surface of the frame 1.

The cutter 8 holds two blade supporting plates 11 inserted in a lower split portion of the supporting shaft 9 by means of a setscrew tightened horizontally. Specifically, a blade piece 12 is pinched and held between the two blade supporting plates 11 while being offset sideways with respect to the axial line of rotation of the cutter 8.

The upper end of the supporting shaft 9 has a nut 10 tigthened thereto, the lower surface of this nut 10, defining a shoulder portion, is supported by the upper end of the bearing 7. The lower end of the bearing 7 and an intermediate stepped portion of the supporting shaft 9 are dimensioned so as to leave a slight gap 20 there between. The blade piece 12 is prepared by folding a notch-provided plate-like cutter blade element sold on the market with a notch and separating one piece therefrom and is supported as shown in the drawings such that its cutting point 13 projects about 1 mm from the lower surface of the frame 1.

The upper surface portion of the supporting arm 2 in the vicinity of its curved portion 4 holds the base end 15 of a spring plate 14 secured thereto with a washer 18 and a lock bolt 17. The distal end 16 of the spring plate 14 is placed on an upper ball-shaped portion of the supporting shaft 9, so that the cutter 8 as a whole is pushed downward.

Thus in this embodiment, the cutter 8 is pushed by the spring plate 14 with a defined pressure or force of about 20 g, but it can turn freely about the central axial line of the supporting shaft 9.

When performing the cutting work the device is positioned, i.e. the cutting point 13 of the cutter 8 is placed on the mask film superposed on an orginal photo while being observed through the hollow portion 19 of the frame 1 such that the cutting point coincides with the starting position of cutting, and then the work is started by causing the cutting point 13 to cut into the film.

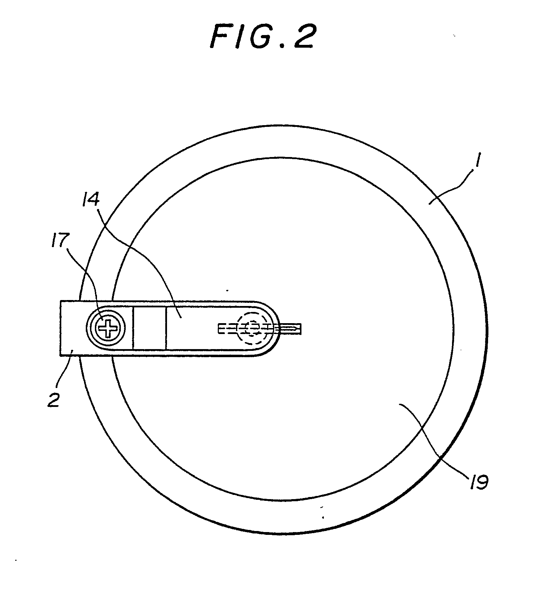

In the course of proceeding with the work, it is possible to look at the original photo and the position of the cutting point 13 through the hollow portion 19. Further, since the cutting point 13 is offset (see Figs. 1, 2) from the axial line of rotation of the cutter 8 and the cutter 8 as a whole turns about this axial line as the frame 1 moves, when the frame 1 is slid and moved on the film by the hand, a cutting edge extending obliquely upward from the cutting point 13 always points to the advancing direction of the frame; thus the cutting work can be performed accurately and easily.

Another embodiment shown in Fig. 3 is identical in configuration with the embodiment of Fig. 1 except for the general configuration of the cutter 8', that is, this cutter 8' is simplified such that a small blade piece 12' is directly held at the lower end of a supporting shaft 9' rotatably supported by the bearing 7. A cutting point 13' of the blade piece 12', similar to the embodiment of Fig. 1, is slightly offset from the axial line of rotation of the cutter 8' which is the central axial line of the supporting shaft 9'; hence, this embodiment provides the same function and effect as those of the embodiment of Fig. 1.

A second embodiment shown in Figs. 4 through 7 is an improved cutting device which is provided with means for adjusting the pressing force of the cutter and a lens for facilitating clear observation of the work.

In these drawings, reference numeral 1 designates a frame of hollow cylindrical shape which has a lower flat sliding surface. The outer periphery of this frame 1 of about 6 cm in outer diameter holds an inverted L-shaped supporting arm 2 made of aluminum whose base end portion 2a is secured to one side of the frame by a setscrew 6. A distal end portion 2b of this arm extends to above a central portion of the hollow portion 4 of the frame 1. At the distal end portion 2b a supporting member 7 is fixed thereto, which has an axial line of rotation being orthogonal to the lower sliding surface 1a of the frame 1 and which holds a cutter 8 having a cutting edge with an inclined cutting point 8a as shown in Fig. 7.

As shown in Fig. 6, the cutter supporting member 7 has a cutter supporting shaft 9 which is vertically movably held in a hollow shaft hole 21 but is prevented from falling off by a border distal end portion 7a. This cutter supporting shaft 9 has a hollow portion 22 in its lower section; this hollow portion has a receiving portion 9a for fit-receiving the cutter 8 at its lower end and another receiving portion 9b for pivot-receiving an upper pointed portion 8b of the cutter 8 at is upper end. Specifically, an upper section of the cutter 8 including the pointed portion 8b as shown in Fig. 7a is inserted in the hollow portion 22 and rotatably held therein, which is prevented from falling out with grease therein. It should be noted that because the cutter is small in size and light in weight it can turn freely but never fall out by virtue of the adhesive strength of the grease.

Further, the cutter supporting member 7 has a cutter pressing force adjusting screw 23 engaged with a female thread 7c formed in the hollow shaft hole 21 of its upper section 7b, by which the force pressing the cutter supporting shaft 9 and the cutter 8 downward via a ball bearing 24 and a coiled spring 25 can be adjusted. It should be noted that the ball bearing is provided for the purpose of preventing a turning of the adjusting screw 23 from causing a bad influence on the coiled spring.

The cutter supporting member 7 has a male thread 7d formed on the outer periphery of the upper section 7b, by which the cutter supporting member 7 is fitted and secured to the distal end portion 2b of the cutter supporting arm 2.

Further, secured by adequate means to a curved portion 2b of the cutter supporting arm 2 is a base portion 27a of a curvature-adjustable supporting rod 27 which has a magnifying lens 26 attached to its distal end. This supporting rod is made of soft aluminum, lead or the like so that it can be bent into a desired shape to adjust the position of the lens as required.

Thus in the cutting device, as shown since the cutting point of the cutter is offset sideways from the axial line of rotation of the cutter as shown, when the frame 1 is slid and moved by the hand, the cutter 8 turns about that axial line in response to the moving of the frame so that the cutting edge of the cutter will always face in or point to, respectively, the advancing direction of the frame. Further, according to this embodiment, since the cutter supporting shaft 9 is pressed via the coiled spring by the cutter pressing force adjusting screw fitted to the upper end of the cutter supporting member 7 and the cutter is rotatably held in the hollow portion 22 of the cutter supporting shaft, the pressure of the cutting point can be adjusted without causing a bad influence on the turning of the cutter. Further, since the magnifying lens is attached to the distal end of the bendable supporting rod whose base portion is secured to the cutter supporting arm, it is possible when carrying out the work, the fully look at a picture to be masked and the movement of the cutting point, whereby the cutting work can be achieved satisfactorily.

As described above, according to the present invention, the cutting work can be conducted in a stable state where the cutting device is simply placed on the mask film, the cutting process can be carried out with the same conditions with respect to all directions with a certain adequate pressing force established by the resilient means, and the cutting can be advanced smoothly in all directions because the supporting shaft serving as the mandrel of the cutter is always kept vertical.

Further, as illustrated in connection with the first embodiment, a ready-made cutter element can be employed as the blade piece, this saving costs. Further, according to the present invention, since the cutter is pressed via the coiled spring by the adjusting screw provided in the upper section of the cutter supporting member, the pressing force acting on the cutting point can be adjusted without causing a bad influence on the turning action of the cutter, and the magnifying lens can be positioned such that the worker can clearly look at the cutting point and the original photo.

Therefore, the use of the device of the present invention avoids a possibility that an excessive force is imposed to damage the cutting edge. This would result if the work is performed with the cutter directly supported by the hand, and another possibility is that the cutting becomes inaccurate. This would result if the blade piece is not kept vertical; hence, the cutting work of making a cut mask can be achieved easily and accurately with no need for any skill.

## Claims

1. A cutting device used in making a cut mask **characterized by** comprising
a frame (1) of hollow cylindrical shape having a lower flat sliding surface,
a supporting arm (2) secured to the frame (1),
a rotatable cutter (8) supported by a cutter supporting member (7) secured to the distal end (5) of the supporting arm (2) whose axial line of rotation is orthogonal to the lower sliding surface, and
a resilient means (14, 15) for causing the cutter (8) to be supported vertically resiliently,
wherein the cutter (8) has a cutting point (8a) offset in a distance or sideways, respectively, form the axial line of rotation.

2. A cutting device according to claim 1,
**characterized in that**
the supporting arm (2) is provided with a curvature-adjustable supporting rod (27) having a magnifying lens (26) attached to its distal end for magnifying a view around the cutting point.

3. A cutting device according to one of claims 1 or 2,
**characterized in that**
the cutter (8) has a supporting shaft (9) supported rotatably and slidable by the supporting member (7), the supporting shaft (9) has a limit segment (10) for limiting its downward movement, and the resilient means is a spring plate (14) attached to the supporting arm (2) for pressing the upper end of the supporting shaft (9).

4. A cutting device according to one of claims 1 or 2, wherein the cutter supporting member (7) has a bored distal end portion by whose hollow portion a portion of the cutter (8) is held, the resilient means is a spring (25) held in the hollow portion for pressing the cutter (8), and the cutter supporting member (7) is provided with means (23, 70) for adjusting the pressing force of the spring (25).

## FIG. 1

## FIG. 3

# FIG.2

# FIG.4

# FIG.5

# FIG. 6

23
7c
7b
7d
24
7
25
21
9
9b
8b
7a
9a
22
8
8a

# FIG. 7(a)  FIG. 7(b)

8b
8
8
8a

# FIG. 7(c)

6